# EUROPEAN PATENT SPECIFICATION

(11) **EP 2 644 508 B1**
(45) Date of publication and mention of the grant of the patent: **04.03.2015**
(21) Application number: 13160769.9
(22) Date of filing: 25.03.2013
(51) Int. Cl.: B64D 37/34, F02C 7/224, H05K 7/20, B64D 37/30, B64D 13/06

(54) **System and method for cooling electrical components**
System und Verfahren zur Kühlung elektrischer Komponenten
Système et procédé de refroidissement de composants électriques

(30) Priority: 29.03.2012 US 201213434644
(43) Date of publication of application: 02.10.2013
(73) Proprietor: General Electric Company, Schenectady, New York 12345 (US)
(72) Inventor: Bray, James William, Niskayuna, NY New York 12309 (US)
(74) Representative: Williams, Andrew Richard

(56) References cited:
- EP-A2- 2 413 681
- US-A1- 2010 242 492

## Description

The performance of many electrical components (e.g., electrical components on-board an aircraft) is dependent upon the temperature at which the electrical component operates. Specifically, many electrical components generate heat during operation. The heat can build up to an extent that the operating temperature of an electrical component negatively affects the performance of the electrical component. For example, the speed at which a processor processes signals may be reduced when the processor operates at higher operating temperatures. Moreover, and for example, the efficiency of an electrical power component that supplies electrical power may be reduced when the electrical power component operates at higher operating temperatures. Higher operating temperatures may also decrease the operational life of an electrical component. Accordingly, it may be desirable to cool an electrical component during operation thereof to maintain the operating temperature of the electrical component below a predetermined threshold.

EP 2,413,681 A2 relates to a cooling plate for an aircraft electrical control in which the cooling plate is maintained separate from the control - this document discloses a cooling system and a method in accordance with the preamble of claims 1 and 11 herein, respectively. US 2010/0242492 A1 discloses distributed engine control systems for gas turbine engines.

In one embodiment, a cooling system is provided for cooling an electrical component. The cooling system includes a supply of liquid natural gas (LNG) and a heat sink configured to be positioned in thermal communication with the electrical component. The cooling system also includes an LNG conduit configured to be interconnected between the heat sink and the supply of LNG such that the LNG conduit is configured to carry LNG from the supply to the heat sink. A pump is configured to be operatively connected in fluid communication with the supply of LNG. The pump is configured to move LNG within the LNG conduit from the supply to the heat sink.

In another embodiment, a method is provided for cooling an electrical component. The method includes supplying a flow of liquid natural gas (LNG) from a supply of the LNG to a heat sink that is positioned in thermal communication with the electrical component. The method also includes dissipating heat from the electrical component by absorbing heat from the heat sink using the LNG.

In another embodiment, an aircraft includes an airframe, an electrical component on-board the airframe, and a cooling system on-board the airframe. The cooling system includes a supply of liquid natural gas (LNG), a heat sink positioned in thermal communication with the electrical component, and an LNG conduit interconnected between the heat sink and the supply of LNG such that the LNG conduit is configured to carry LNG from the supply to the heat sink. A pump is operatively connected in fluid communication with the supply of LNG. The pump is configured to move LNG within the LNG conduit from the supply to the heat sink.
Figure 1 is a schematic illustration of an embodiment of a cooling system for cooling an electrical component.
Figure 2 is a schematic illustration of an embodiment of an aircraft.
Figure 3 is a flowchart illustrating an embodiment of a method for cooling an electrical component.
Figure 4 is a perspective view of an embodiment of a heat sink.
Figure 5 is a perspective view of another embodiment of a heat sink.
Figure 6 is a cross sectional view of a portion of an embodiment of a liquid natural gas (LNG) conduit.

The following detailed description of certain embodiments will be better understood when read in conjunction with the appended drawings. It should be understood that the various embodiments are not limited to the arrangements and instrumentality shown in the drawings.

As used herein, an element or step recited in the singular and preceded with the word "a" or "an" should be understood as not excluding plural of said elements or steps, unless such exclusion is explicitly stated. Furthermore, references to "one embodiment" are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

Various embodiments of systems and methods are provided for cooling electrical components using liquid natural gas (LNG). At least one beneficial effect of various embodiments is an electrical component having an increased operational life span and/or increased performance (such as, but not limited to, higher speed, greater efficiency, and/or the like). For example, at least one beneficial effect of various embodiments may be a processor that processes signals at higher speeds. Moreover, and for example, at least one beneficial effect of various embodiments may be an electrical power component that operates at a greater efficiency. At least one other beneficial effect of various embodiments is the ability to cool electrical components using LNG that is contained on-board an aircraft for use as fuel for an engine of the aircraft.

The various embodiments of cooling systems and methods are described and illustrated herein with respect to being used for cooling electrical components on-board an aircraft. But, the various embodiments of cooling systems and methods are not limited to being used with aircraft. Rather, the various embodiments of cooling systems and methods may be used to cool any type of electrical component that is located on any stationary and/or mobile platform, such as, but not limited to, trains, automobiles, watercraft (e.g., a ship, a boat, a maritime vessel, and/or the like), and/or the like. Additionally, the various embodiments of cooling systems and methods are described and illustrated herein with respect to a fixed wing airplane. But, the various embodiments of cooling systems and methods are not limited to airplanes or fixed wing aircraft. Rather, the various embodiments of cooling systems and methods may be implemented within other types of aircraft having any other design, structure, configuration, arrangement, and/or the like, such as, but not limited to, aerostats, powered lift aircraft, and/or rotorcraft, among others.

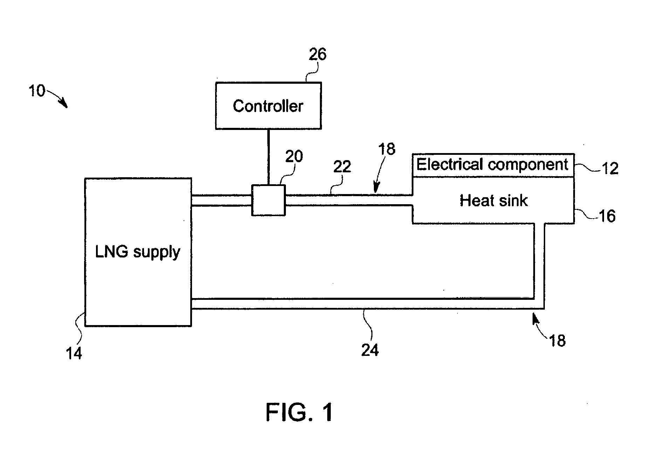

Figure 1 is a schematic illustration of an embodiment of a cooling system 10. The cooling system 10 is used to cool one or more electrical components 12 using LNG. LNG has a temperature of approximately 111 K and may be considered cryogenic. Accordingly, LNG may be a suitable cooling medium for electrical components 12 that operate at temperatures above approximately 111 K. The cooling system 10 may be used to cool any number of electrical components 12. For clarity, the cooling system 10 will be described and illustrated with reference to Figure 1 as cooling a single electrical component 12. Each electrical component 12 may be any type and quantity of electrical component, such as, but not limited to, signal processor, power distribution component, power source, capacitor, an electrical component that processes, transmits, or relays data, and/or the like.

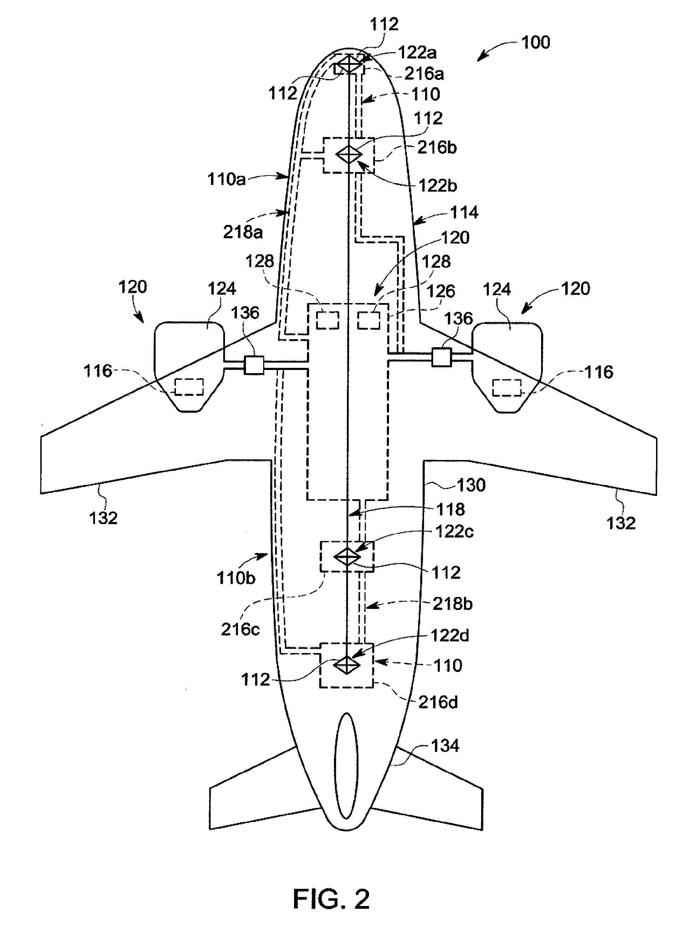

The cooling system 10 in this embodiment includes a supply 14 of LNG, a heat sink 16, an LNG conduit system 18, and a pump 20. The supply 14 is configured to hold a supply of LNG and may be thermally insulated and/or provided with a cooling system (not shown) to enable the supply to store the natural gas in the liquid state. As will be described below, the supply 14 may be a fuel tank of an aircraft (e.g., the fuel tank 126 of the aircraft 100 shown in Figure 2) such that the cooling system 10 shares the same supply and may share some of the piping, pumps, controller functionality, and/or the like.

The heat sink 16 in this example is positioned in thermal communication with the electrical component 12. For example, the heat sink 16 may engage the electrical component 12 and/or the heat sink 16 may engage a thermal interface material (TIM, not shown) that is engaged with the electrical component 12. In the illustrated embodiment, the heat sink 16 is positioned in thermal communication with a single electrical component 12. But, the heat sink 16 may be positioned in thermal communication with any number of electrical components 12. In one example, the heat sink 16 can be deployed on more than one side of the electrical component 12. The heat sink 16 may include one or more cooling fins (not shown). In some embodiments, the heat sink 16 is a fluid block.

The LNG conduit system 18 is fluidly interconnected between the supply 14 and the heat sink 16 for carrying LNG from the supply 14 to the heat sink 16. In the illustrated embodiment, the LNG conduit system 18 includes LNG conduits 22 and 24. Each of the LNG conduits 22 and 24 is fluidly interconnected between the supply 14 and the heat sink 16. In other words, each of the LNG conduits 22 and 24 provides a fluid path between the supply 14 and the heat sink 16. The LNG conduit 22 and/or the LNG conduit 24 may be thermally insulated along at least a portion of the length thereof to facilitate maintaining the LNG below a predetermined temperature. For example, the LNG conduit 22 and/or the LNG conduit 24 may be thermally insulated to facilitate maintaining the LNG in the liquid state. Any type of thermal insulation may be used, such as, but not limited to, pipe insulation, mineral wool, glass wool, an elastomeric foam, a rigid foam, polyethylene, aerogel, a double-walled conduit (e.g., with a vacuum between the walls), and/or the like. The thermal insulation may be applied to the LNG conduit 22 and/or 24 in any manner, such as, but not limited to, extending around the LNG conduit 22 and/or 24, being wrapped around the LNG conduit 22 and/or 24, and/or the like.

The LNG conduit 22 is a supply conduit that is configured to carry LNG from the supply 14 to the heat sink 16. In the illustrated embodiment, the LNG conduit 24 is a return conduit that is configured to carry, or return, LNG from the heat sink 16 to the supply 14. Accordingly, in the illustrated embodiment, the LNG is returned to the supply 14 after being used to cool the electrical component 12. In other words, the LNG conduit system 18 is a closed loop system in the illustrated embodiment. In other embodiments, the LNG conduit system 18 is an open loop system wherein the LNG is not returned to the supply 14 after being used to cool the electrical component 12. Rather, in such other embodiments, after being used to cool the electrical component 12 the LNG is carried to another component, such as, but not limited to, a waste or other type of collection container (not shown), an engine, a furnace, and/or the like. For example, after being used to cool the electrical component 12, there may be a complete or partial vaporization of the LNG, and such vapor may be supplied to an engine for use as fuel by the engine, may be disposed of as waste, and/or may be reliquified and returned to the supply 14.

In Figure 1, the LNG conduit system 18 is illustrated as a relatively simple system for fluidly interconnecting a single heat sink 16 to the supply 12 of LNG. But, one or more other heat sinks 16 may be fluidly interconnected to the supply 14 by the LNG conduit system 18. The LNG conduit system 18 may thus be used to supply LNG to a plurality of heat sinks 16. Each of such other heat sinks 16 may be positioned in thermal communication with any number of electrical components 12. Moreover, each of such other heat sinks 16 may be fluidly interconnected in series or parallel with the heat sink 16 shown in Figure 1. Accordingly, such other heat sinks 16 may include one or more heat sinks 16 that is fluidly interconnected to the supply 14 of LNG in series with the heat sink 16 shown in Figure 1 and/or one or more heat sinks 16 that is fluidly interconnected to the supply 14 of LNG in parallel with the heat sink 16 shown in Figure 1. The LNG conduit system 18 may include any number of LNG conduits, which may be arranged in any pattern, paths, and/or the like, for fluidly interconnecting any number of heat sinks 16 to the supply 14 of LNG.

The pump 20 is operatively connected in fluid communication with the supply 14. Operation of the pump 20 moves LNG within the LNG conduit system 18. For example, the pump 20 moves LNG within the LNG conduit 22 from the supply 14 to the heat sink 16. In the illustrated embodiment, the pump 20 also moves LNG within the LNG conduit 24 from the heat sink 16 to the supply 14. In other embodiments wherein the LNG is not returned to the supply 14 after being used to cool the electrical component 12, the pump 20 may move the LNG within the LNG conduit 24 from the heat sink 16 to another component as described above. Although only a single pump 20 is shown, the cooling system 10 may include any number of pumps 20. Each pump 20 may have any location within the cooling system 10 that enables the pump 20 to move LNG within the LNG conduit system 18. For example, the illustrated embodiment of the pump 20 is located along the LNG conduit 22. But, other exemplary locations of the pump 20 include a location along the LNG conduit 24, a location within the supply 14, and/or the like. Each pump 20 may be any type of pump that enables the pump 20 to move LNG within the LNG conduit system 18, such as, but not limited to, a positive displacement pump, an impulse pump, a hydraulic ram pump, a velocity pump, a centrifugal pump, an educator-jet pump, a gravity pump, a valve less pump, and/or the like. In some embodiments, the pump 20 is a fuel pump for an engine. In some embodiments, the pump 20 may be located such that the pump 20 does not directly contact the LNG but operates at ambient temperatures, such as, but not limited to, by pressurizing the supply 14 of LNG. Such a location of the pump 20 may be easier and/or less costly to implement.

The cooling system 10 may include a controller 26 or other sub-system for controlling operation of the cooling system 10. For example, the controller 26 may control activation and deactivation of operation of the cooling system 10. Moreover, and for example, the controller 26 may control operation of the pump 20, any valves (not shown) of the cooling system 10, and/or any other components of the cooling system 10. The controller 26 may control various operations of the pump 20, such as, activation and deactivation of the pump 20, a flow rate of the LNG provided by the pump 20, and/or the like. Other exemplary operations of the controller 26 include, but are not limited to, monitoring one or more sensors (not shown) that determine operating and/or other temperatures of the electrical component 12, controlling valves to control the flow of LNG to different heat sinks 16 of the cooling system 10, and/or the like. Other sensors may be integrated into the system 10 to monitor LNG pressure, LNG temperature, LNG velocity, and/or the like within the LNG conduit system 18. Moreover, in an aircraft application, other sensors may be used to maintain the integrity and safety of the aircraft, which may include efficiency of operations that may use the LNG supply up to a margin required for cooling.

Operation of the cooling system 10 to cool the electrical component 12 will now be described. The electrical component 12 generates heat during operation thereof. The thermal communication between the heat sink 16 and the electrical component 12 enables the heat sink 16 to absorb at least some of the heat generated by the electrical component 12. A flow of the LNG is supplied from the supply 14 to the heat sink 16. The flow of LNG is supplied to the heat sink 16 such that the LNG flows along and/or within the heat sink 16 in thermal communication therewith. In one example, the heat sink 16 includes one or more channels that provide for fluid communication of the LNG. The thermal communication between the LNG flow and the heat sink 16 enables the LNG to absorb at least some heat from the heat sink 16. The LNG thus dissipates at least some heat from the electrical component 12 through the heat sink 16. In some embodiments, the LNG absorbs enough heat from the heat sink 16 such that the LNG changes to a gaseous state and/or vaporizes.

The cooling system 10 may be used to dissipate any amount of heat from the electrical component 12. For example, the cooling system 10 may cool the electrical component 12 to any operating temperature or range thereof. Examples of operating temperatures or ranges thereof to which the cooling system 10 may cool the electrical component include, but are not limited to, an operating temperature of below approximately 300 K, an operating temperature of below approximately 250 K, an operating temperature of below approximately 160 K, an operating temperature of between approximately 130 K and 170 K, an operating temperature of between approximately 140 K and 160 K, and/or the like. Such operating temperatures may be achieved by balancing the LNG flow along and/or through the heat sink 16 with the rate of heat generation by certain components 12.

Various parameters of the various components of the cooling system 10 may be selected to adapt the functionality of the system 10 to a specific application, to provide the system 10 with a predetermined functionality (e.g., a cooling capability of the system 10, the number of electrical components 12 that the system 10 is used to cool, the efficiency of the system 10, the type(s) of electrical components 12 that the system 10 is used to cool, and/or the like), and/or the like. Examples of such various parameters include, but are not limited to, the dimensions and/or materials of the heat sink 16, the dimensions of the various conduits of the LNG conduit system 18, the pressure(s) within the LNG conduit system 18, the volume and/or velocity of flow within the LNG conduit system 18, the amount of LNG contained within the cooling system 10, the use of various conduit features (e.g., valves, restrictors, blowouts, manual shutoffs, automatic shutoffs, and/or the like), and/or the like.

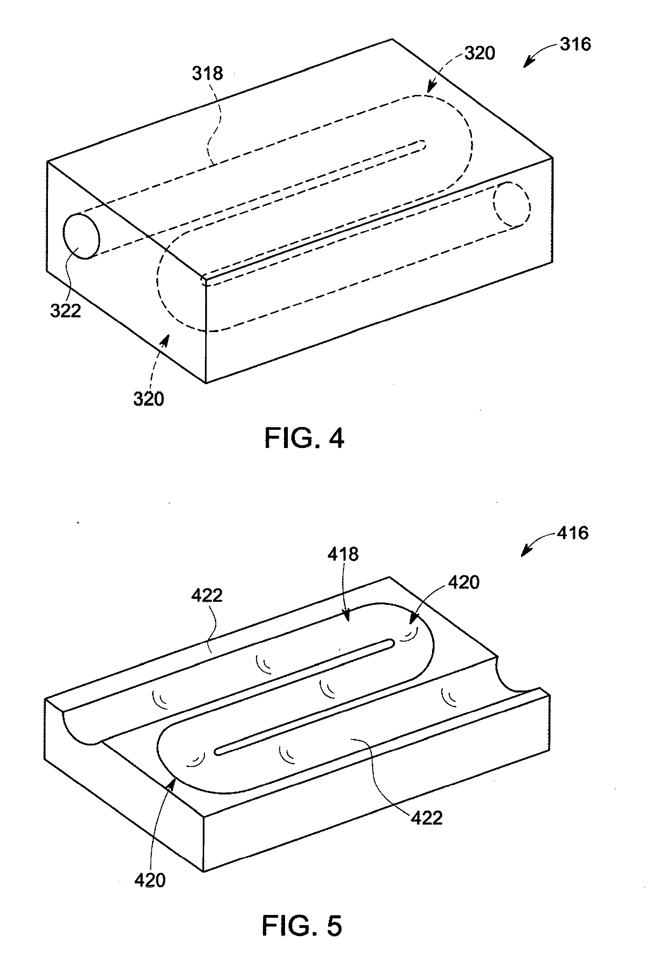

The heat sink 16 may be configured to be in thermal communication with the LNG flow received from the supply 14 using any arrangement, means, structure, configuration, and/or the like. For example, the flow of LNG may engage the heat sink 16 to establish the thermal communication therebetween. Moreover, and for example, the LNG flow may thermally communicate with the heat sink 16 through one or more intervening structures (e.g., a conduit wall, a TIM, and/or the like) that is engaged between the LNG flow and the heat sink 16. Exemplary configurations for establishing the thermal communication between the LNG and the heat sink 16 will be described below with reference to Figures 4 and 5.

The cooling system 10 may be used to cool electrical components that are located on-board an aircraft. For example, Figure 2 is a schematic illustration of an embodiment of an aircraft 100 that includes a cooling system 110 that uses LNG in a substantially similar manner to the cooling system 10 (Figure 1). In the illustrated embodiment, the aircraft 100 is a fixed wing passenger airplane. The aircraft 100 includes a plurality of electrical components 112, an airframe 114, a source 116 of electrical power, a power distribution system 118, an engine system 120, and the cooling system 110. The source 116, the electrical components 112, the power distribution system 118, the engine system 120, and the cooling system 110 are each located on-board the airframe 114. Specifically, the source 116, the electrical components 112, the power distribution system 118, the engine system 120, and the cooling system 110 are positioned at various locations on and/or within the airframe 114 such that the source 116, the electrical components 112, the power distribution system 118, the engine system 120, and the cooling system 110 are carried by the airframe 114 during flight of the aircraft 100.

The power distribution system 118 is configured (e.g., operatively connected) between the source 116 and the electrical components 112 to carry electrical power from the source 116 to the electrical components 112. The source 116 may be any type of source of electrical power, for example a generation device or a storage device. In the illustrated embodiment, the aircraft 100 includes two sources 116 that are each turbine generators associated with the engine system 120 of the aircraft 100. Other examples of the source 116 as a generation device include electrical generators and/or solar cells, among others. Examples of the source 116 as a storage device include fuel cells, batteries, flywheels, and/or capacitors, among others. Although shown as being located at the engine system 120 of the aircraft 100, each source 116 may be located at any other location along the airframe 114. Moreover, although two are shown, the aircraft 100 may include any number of the sources 116.

Sub-sets 122 of the electrical components 112 are shown in Figure 2 at various locations along the airframe 114. Each sub-set 122 may include any number of electrical components 112. In some embodiments, one or more sub-sets 122 only includes a single electrical component 112. When a sub-set 122 includes two or more electrical components 112, all of the electrical components 112 of the sub-set 122 may be of the same type or the sub-set 122 may include two or more different types of electrical components 112. The aircraft 100 may include any number of the sub-sets 122. In some embodiments, it may be advantageous to arrange the sub-sets 122 such that electrical components 112 that benefit from cooling using the LNG are grouped together. Such sub-sets 122 may be cooled using LNG as described and/or illustrated herein, while sub-sets 122 that do not benefit from cooling using LNG are left uncooled and/or are cooled by other means.

The locations and pattern of sub-sets 122 along the airframe 114 shown in Figure 2 are for example only. Each sub-set 122 may have any other location along the airframe 114 and the sub-sets 122 may be arranged in any other pattern relative to each other. Moreover, the electrical components 112 of the same sub-set 122 are shown in Figure 2 as grouped together at the same location along the airframe 114 for illustrative purposes only. The electrical components 112 of the same sub-set 122 need not be located at the same location along the airframe 114. Rather, each electrical component 112 may have any location along the airframe 114, whether or not such location is the same, or adjacent to, the location of one or more other electrical components 112 of the same sub-set 122. In some embodiments, the electrical components are grouped together in the sub-sets 122 based on corresponding power distribution modules (not shown) of the power distribution system 118 that are common to groups (i.e., the sub-sets 122) of the electrical components 112.

Each electrical component 112 of each sub-set 122 may be any type of electrical component. Examples of the electrical components 112 include flight controls, avionics, displays, instruments, sensors, galley ovens, heaters, refrigeration units, lighting, fans, de-ice and anti-ice systems, engine management systems, flight management systems, power distribution components, starters, starter-generators, environmental controls, pressurization systems, entertainment systems, microwaves, weapon systems, and/or cameras, among others.

The engine system 120 includes one or more engines 124 and one or more fuel tanks 126. The fuel tank 126 contains a supply of fuel. Each of the engines 124 is operatively connected in fluid communication to receive fuel from one or more of the fuel tanks 126. The engines 124 use the fuel supplied from the fuel tanks 126 to generate thrust for generating and controlling flight of the aircraft 100. The engine system 120 may include one or more fuel pumps 128. Each fuel pump 128 is operatively connected in fluid communication with one or more corresponding fuel tanks 126 and with one or more corresponding engines 124 for pumping fuel from the fuel tank(s) 126 to the engine(s) 124.

The aircraft 100 may include any number of fuel tanks 126, each of which may have any location along the airframe 114. In the illustrated embodiment, the aircraft 100 includes a single fuel tank 126 that is located within a fuselage 130 of the airframe 114. Examples of other locations of fuel tanks 126 include, but are not limited to, fuel tanks (not shown) located within corresponding wings 132 of the airframe 114. The aircraft 100 may include any number of fuel pumps 128. Each fuel pump 128 may have any location along the airframe 114. In the illustrated embodiment, the fuel pumps 128 are located within the fuel tank 126. Examples of other locations of fuel pumps include, but are not limited to, mounted to a corresponding engine 124, located proximate a corresponding engine 124, and/or the like.

Each engine 124 may be any type of engine, such as, but not limited to, a turbine engine, an engine that drives a propeller or other rotor, a radial engine, a piston engine, a turboprop engine, a turbofan engine, and/or the like. Although two are shown, the aircraft 100 may include any number of the engines 124. Although shown located on the wings 132 of the airframe 114, each engine 124 may have any other location along the airframe 114. For example, the aircraft 100 may include an engine 124 located at a tail 134 and/or another location along the fuselage 130 of the airframe 114.

Each engine 124 may use any type(s) of fuel, such as, but not limited to, a petroleum-based fuel, hydrogen, natural gas, and/or the like. In the exemplary embodiment, the engines 124 are configured to use at least natural gas as fuel. The fuel tank 126 is configured to hold a supply of LNG. The fuel tank 126 may be thermally insulated and/or provided with a cooling system (not shown) to enable the fuel tank 126 to store the natural gas in the liquid state. The engines 124 use the natural gas as fuel in the gaseous state. The engine system 120 may include one or more heating systems 136 that heat the LNG stored by the fuel tank 126 to change the LNG stored by the fuel tank 126 to the gaseous state for supply to the engines 124 as fuel.

In some other embodiments, one or more of the engines 124 is configured to use both natural gas and one or more other types of fuel, whether at the same and/or different times. Moreover, in some other embodiments, one or more of the engines 124 is not configured to use natural gas as a fuel. Accordingly, it should be understood that the aircraft 100 may include a fuel tank (not shown) that holds a different type of fuel than natural gas. It should also be understood that the aircraft 100 may include one or more other supplies of LNG that is not a fuel tank for an engine 124. In other words, the aircraft 100 may include one or more supplies of LNG that is not a component of the engine system 120.

The cooling system 110 includes a supply of LNG. In the illustrated embodiment, the LNG supply of the cooling system 110 is the fuel tank 126. In other embodiments, the cooling system 110 includes a supply of LNG that is separate from the fuel tank 126 (e.g., a supply that is not a fuel tank). Moreover, in some embodiments, a backup supply of LNG is provided for supplying the cooling system 110 with LNG when the supply of LNG from a main supply (e.g., the fuel tank 126 in the illustrated embodiment) is interrupted. In the illustrated embodiment, the cooling system 110 includes two cooling circuits 110a and 110b. The cooling circuit 110a is used to cool sub-groups 122a and 122b of the electrical components 112, while the cooling circuit 110b cools the sub-groups 122c and 122d of the electrical components 112. The cooling system 110 may include any number of cooling circuits. Each cooling circuit may cool any number of electrical components 112 and any number of sub-groups 122.

The cooling circuit 110a includes one or more heat sinks 216a, an LNG conduit system 218a, and a pump. Similarly, the cooling circuit 110b includes one or more heat sinks 216b, an LNG conduit system 218b, and a pump. In the illustrated embodiment, the pumps of the cooling circuits 110a and 110b are corresponding fuel pumps 128 of the engine system 120. In other embodiments, the cooling circuit 110a and/or the cooling circuit 110b includes a pump that is separate from the corresponding fuel pump 128 of the engine system 120.

Referring now to the cooling circuit 110a, the LNG conduit system 218a is fluidly interconnected between the fuel tank 126 and the heat sinks 216a of the sub-groups 122a and 122b for carrying LNG from the fuel tank 126 to the heat sinks 216a. In the illustrated embodiment, the heat sinks 216a are fluidly interconnected with the LNG conduit system 218a in parallel with each other. During operation of the cooling circuit 110a, the LNG flow absorbs at least some heat from the heat sinks 216a such that the LNG dissipates at least some heat from the sub-groups 122a and 122b of the electrical components 112. In some embodiments, the LNG absorbs enough heat from the heat sinks 216a such that the LNG changes to a gaseous state and/or vaporizes.

The LNG conduit system 218b of the cooling circuit 110b is fluidly interconnected between the fuel tank 126 and the heat sinks 216b of the sub-groups 122c and 122d for carrying LNG from the fuel tank 126 to the heat sinks 216b. In the illustrated embodiment, the heat sinks 216b are fluidly interconnected with the LNG conduit system 218a in series with each other. During operation of the cooling circuit 110b, the LNG flow absorbs at least some heat from the heat sinks 216b such that the LNG dissipates at least some heat from the sub-groups 122c and 122d of the electrical components 112. In some embodiments, the LNG absorbs enough heat from the heat sinks 216b such that the LNG changes to a gaseous state and/or vaporizes.

In the illustrated embodiment, the LNG conduit systems 218a and 218b are each open loop systems wherein the LNG used to cool the sub-groups 122a, 122b, 122c, and 122d, respectively, is then delivered to the engines 124 for use as fuel by the engines 124. Alternatively, the LNG conduit system 218a and/or 218b is a closed-loop system wherein the LNG is returned to the fuel tank 126 after being used to cool the respective sub-groups 122a, 122b, 122c, and 122d. In another example, the closed loop system can provide some portion of the LNG to the engines 124 and some portion back to the fuel tank 126.

As described above, the engines 124 use natural gas as fuel in the gaseous state. The heat absorbed by the flow of LNG increases the temperature of the LNG. The increase in temperature of the LNG after cooling the electrical components 112 may facilitate supplying the LNG to the engines 124 in a gaseous state. For example, the heat absorbed by the flow of LNG may increase the temperature of the LNG toward a supply temperature at which the LNG is supplied to the engines 124 in a gaseous state. The increase in temperature of the LNG via the heat sinks 216 may replace the heating system 136 or may supplement the heating system 136. For example, in some embodiments, the heat absorbed by the LNG from the heat sinks 216 is sufficient to raise the temperature of the LNG to the supply temperature, wherein the aircraft 100 may or may not include the heating system(s) 136. In other embodiments, the heat absorbed by the LNG from the heat sinks 216 may not be sufficient to raise the temperature of the LNG to the supply temperature. In such embodiments, the LNG is further heated by the heating system 136 to raise the temperature of the LNG to the supply temperature (whether it is the heat absorbed by the heat sinks or the heat applied by the heating system 136 that vaporizes and/or changes the LNG to a gaseous state). Various temperature sensors can be deployed throughout the cooling system 110 to monitor the temperature and determine whether the heating system 136 is required to raise the LNG temperature.

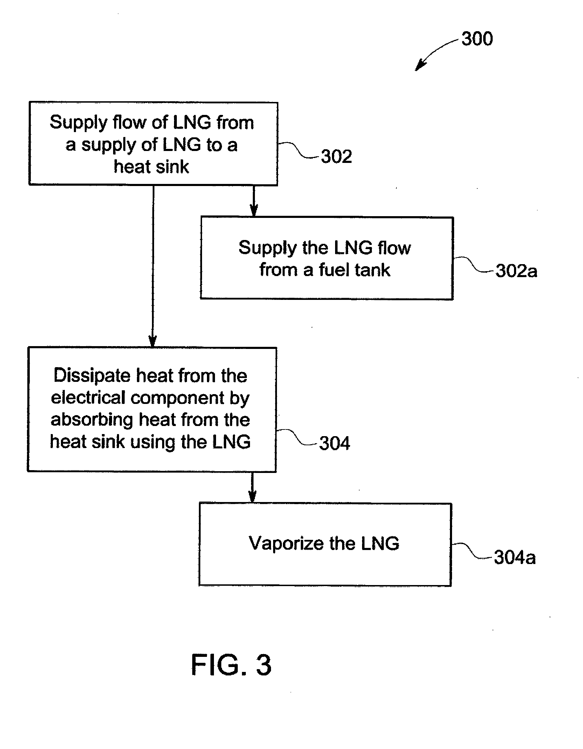

Figure 3 is a flowchart illustrating an embodiment of a method 300 for cooling an electrical component. For example, the method 300 may be preformed using the cooling system 10 (Figure 1) or the cooling system 110 (Figure 2). The method 300 includes, at 302, supplying a flow of LNG from a supply of the LNG to a heat sink that is positioned in thermal communication with the electrical component. 13. In some embodiments, supplying at 302 the LNG flow to the heat sink includes supplying, at 302a, the flow of LNG from a fuel tank (e.g., the fuel tank 126 shown in Figure 2) of an aircraft engine.

At 304, the method 300 includes dissipating heat from the electrical component by absorbing heat from the heat sink using the LNG. Any amount of heat may be dissipated at 304 from the electrical component. For example, the electrical component may be cooled to a desired operating temperature or range of the electrical component. In some embodiments, the LNG absorbs enough heat from the heat sink such that the LNG changes to a gaseous state and/or vaporizes. For example, the step 304 of dissipating heat from the electrical component may include, at 304a, at least partially vaporizing the LNG. The vaporized LNG can be vaporized directly from the interaction with the heat sink and/or via a heating system such that the vaporized LNG is used as fuel for an engine. In one example, at least some of the LNG is returned to the supply. In some embodiments, dissipating at 304 includes increasing the temperature of the LNG toward a supply temperature at which the LNG is supplied to an engine in a gaseous state for use by the engine as fuel.

Figure 4 is a perspective view of an embodiment of a heat sink 316 that may be used with the cooling system 10 (Figure 1) and/or the cooling system 110 (Figure 2). The heat sink 316 is a fluid block that includes one or more passageways 318 that receives a flow of LNG from an LNG conduit system (e.g., the LNG conduit system 18 shown in Figure 1, the LNG conduit system 218a shown in Figure 2, and/or the LNG conduit system 218b shown in Figure 2). Although shown with the shape of a parallelepiped, the heat sink 316 may additionally or alternatively include any other shape.

In the illustrated embodiment, the heat sink 316 includes a single passageway 318 that extends along a path within the heat sink 316 that includes a plurality of loops 320. But, the heat sink 316 may include any number of the passageways 318, which may each follow any path through the heat sink 316. When a plurality of passageways 318 are provided, the passageways 318 may be arranged in any pattern relative to each other, which may include passageways 318 arranged in series with each other, passageways 318 arranged in parallel with each other, or a combination thereof. In some embodiments, two or more passageways 318 arranged in parallel with each other may be interconnected by an intervening passageway (not shown). The passageways 318 may be arranged in any pattern relative to each other. The number, pattern, path, size, and/or the like of the passageways 318 may be selected to provide a predetermined amount of surface area for thermal communication with the LNG. Although shown as having a cylindrical shape, each passageway 318 may additionally or alternatively include any other shape and may include turbulators of any type.

In the illustrated embodiment, the passageway 318 includes an interior surface 322 of the heat sink 316 that engages the LNG as the LNG flows through the passageway 318. The engagement between the LNG and the interior surface 322 establishes the thermal communication between the LNG and the heat sink 316. Alternatively, the passageway 318 receives an LNG conduit (e.g., the LNG conduit 22 and/or the LNG conduit 24 shown in Figure 1) of the LNG conduit system therethrough. Specifically, a wall of the LNG conduit may be engaged with the interior surface 322 of the passageway 318 to establish the thermal communication between the LNG and the heat sink 316. For example, the LNG conduit may include an insulated segment and an uninsulated segment. The insulated segment may extend a length from the supply of LNG to the heat sink 316 (or vice versa) and is thermally insulated along at least a portion of the length thereof The uninsulated segment extends from the insulated segment through the passageway 318. A wall of the uninsulated segment engages the interior surface 322 of the passageway 318 to establish the thermal communication between the LNG and the heat sink 316.

Figure 5 is a perspective view of another embodiment of a heat sink 416 that may be used with the cooling system 10 (Figure 1) and/or the cooling system 110 (Figure 2). The heat sink 416 includes an exterior surface 422 that engages an LNG conduit (e.g., the LNG conduit 22 and/or the LNG conduit 24 shown in Figure 1) of an LNG conduit system to establish the thermal communication between the LNG and the heat sink 416. Although shown with the shape of a parallelepiped, the heat sink 416 may additionally or alternatively include any other shape.

The LNG thermally communicates with the heat sink 416 through an intervening structure that is engaged between the LNG and the heat sink 416. Specifically, a wall of the LNG conduit engages the exterior surface 422 of the heat sink 416 to establish the thermal communication between the LNG and the heat sink 416. The exterior surface 422 may be approximately flat. Alternatively, and as shown in the illustrated embodiment, the exterior surface 422 includes one or more passageways 418 formed therein. The passageway(s) 418 receives the LNG conduit (e.g., the LNG conduit 22 and/or the LNG conduit 24 shown in Figure 1) of the LNG conduit system therein. For example, the LNG conduit may include an insulated segment and an uninsulated segment. The insulated segment may extend a length from the supply of LNG to the heat sink 416 (or vice versa) and is thermally insulated along at least a portion of the length thereof. The uninsulated segment extends from the insulated segment within the passageway(s) 418.

In the illustrated embodiment, the heat sink 416 includes a single passageway 418 that extends along a path along the exterior surface 422 that includes a plurality of loops 420. But, the heat sink 416 may include any number of the passageways 418, which may each follow any path along the exterior surface 422. When a plurality of passageways 418 are provided, the passageways 418 may be arranged in any pattern relative to each other, which may include passageways 418 arranged in series with each other, passageways 418 arranged in parallel with each other, or a combination thereof. In some embodiments, two or more passageways 418 arranged in parallel with each other may be interconnected by an intervening passageway (not shown). The passageways 418 may be arranged in any pattern relative to each other. The number, pattern, path, size, and/or the like of the passageways 418 may be selected to provide a predetermined amount of surface area for thermal communication with the LNG. Although shown as having a partially cylindrical shape, each passageway 418 may additionally or alternatively include any other shape.

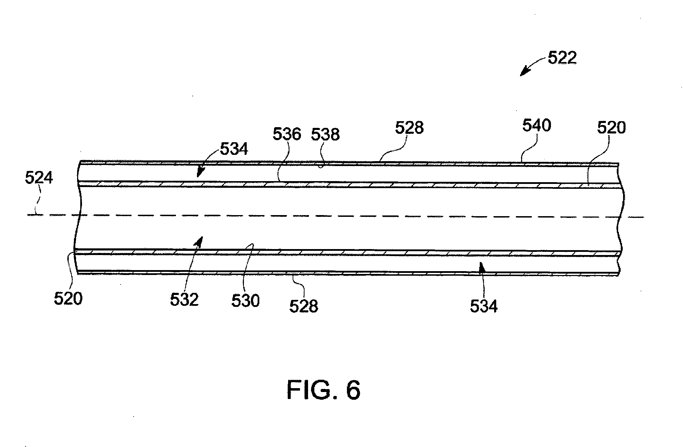

Figure 6 is a cross-sectional view of a portion of an exemplary embodiment of an LNG conduit 522 that may be used with the cooling system 10 (Figure 1) and/or the cooling system 110 (Figure 2). As briefly described above, the LNG conduits described and/or illustrated herein may be thermally insulated along at least a portion of the length thereof. In the illustrated embodiment of Figure 6, the LNG conduit 522 is a double-walled conduit that extends a length along a central longitudinal axis 524.

The LNG conduit 522 includes an inner wall 526 and an outer wall 528. An interior surface 530 of the inner wall 526 defines an inner passageway 532 that is configured to carry a flow of LNG. The outer wall 528 extends radially (relative to the central longitudinal axis 524) around the inner wall 526. The outer wall 528 is spaced radially (relative to the central longitudinal axis 524) apart from the inner wall 526 to define an outer passageway 534. The outer passageway 534 is defined between an exterior surface 536 of the inner wall 526 and an interior surface 538 of the outer wall 528. The outer passageway 534 may have any size.

In the illustrated embodiment, the outer passageway 534 contains a vacuum. The vacuum thermally insulates the LNG flowing through the inner passageway 532. An emissivity-reduction layer (not shown) may be provided within the outer passageway 534. For example, the emissivity-reduction layer may extend on the interior surface 538 of the outer wall 528 and/or may extend on the exterior surface 536 of the inner wall 526. The emissivity-reduction layer may facilitate reducing the emissivity of the outer passageway 534. In other words, the emissivity-reduction layer may facilitate reducing the amount of radiant heat transfer between the LNG flowing within the inner passageway 532 and the ambient environment in which the LNG conduit 522 resides. Examples of the emissivity-reduction layer include, but are not limited to, multiplayer insulation (MLI), silver paint, and/or the like.

In alternative to a vacuum, the outer passageway 534 may contain one or more other thermally insulative materials, such as, but not, limited to, pipe insulation, mineral wool, glass wool, an elastomeric foam, a rigid foam, polyethylene, aerogel, and/or the like. In some embodiments wherein the outer passageway 534 does not contain a vacuum, a heat tape is applied to the inner wall 526 and/or the outer wall 528. For example, heat tape may be wrapped around the exterior surface 536 of the inner wall 526 along at least a portion of the length of the LNG conduit 522 to facilitate vaporizing the LNG and/or changing the LNG to a gaseous state. Moreover, and for example, heat tape may be wrapped around an exterior surface 540 of the outer wall 528 and/or may be wrapped around the exterior surface 536 of the inner wall 526 to facilitate reducing or preventing ice from accumulating around the outer wall 528.

It should be noted that the various embodiments may be implemented in hardware, software or a combination thereof. The various embodiments and/or components, for example, the modules, or components and controllers therein, also may be implemented as part of one or more computers or processors. The computer or processor may include a computing device, an input device, a display unit and an interface, for example, for accessing the Internet. The computer or processor may include a microprocessor. The microprocessor may be connected to a communication bus. The computer or processor may also include a memory. The memory may include Random Access Memory (RAM) and Read Only Memory (ROM). The computer or processor further may include a storage device, which may be a hard disk drive or a removable storage drive such as a solid state drive, optical disk drive, and the like. The storage device may also be other similar means for loading computer programs or other instructions into the computer or processor.

As used herein, the term "computer" or "module" may include any processor-based or microprocessor-based system including systems using microcontrollers, reduced instruction set computers (RISC), ASICs, logic circuits, and any other circuit or processor capable of executing the functions described herein. The above examples are exemplary only, and are thus not intended to limit in any way the definition and/or meaning of the term "computer".

The computer or processor executes a set of instructions that are stored in one or more storage elements, in order to process input data. The storage elements may also store data or other information as desired or needed. The storage element may be in the form of an information source or a physical memory element within a processing machine.

The set of instructions may include various commands that instruct the computer or processor as a processing machine to perform specific operations such as the methods and processes of the various embodiments of the invention. The set of instructions may be in the form of a software program. The software may be in various forms such as system software or application software and which may be embodied as a tangible and non-transitory computer readable medium. Further, the software may be in the form of a collection of separate programs or modules, a program module within a larger program or a portion of a program module. The software also may include modular programming in the form of object-oriented programming. The processing of input data by the processing machine may be in response to operator commands, or in response to results of previous processing, or in response to a request made by another processing machine.

As used herein, the terms "software" and "firmware" are interchangeable, and include any computer program stored in memory for execution by a computer, including RAM memory, ROM memory, EPROM memory, EEPROM memory, and nonvolatile RAM (NVRAM) memory. The above memory types are exemplary only, and are thus not limiting as to the types of memory usable for storage of a computer program.

It is to be understood that the above description is intended to be illustrative, and not restrictive. For example, the above-described embodiments (and/or aspects thereof) may be used in combination with each other. In addition, many modifications may be made to adapt a particular situation or material to the teachings of the invention without departing from its scope. Dimensions, types of materials, orientations of the various components, and the number and positions of the various components described herein are intended to define parameters of certain embodiments, and are by no means limiting and are merely exemplary embodiments. Many other embodiments and modifications within the scope of the claims will be apparent to those of skill in the art upon reviewing the above description. The scope of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, the terms "first," "second," and "third," etc. are used merely as labels, and are not intended to impose numerical requirements on their objects.

## Claims

1. A cooling system (10) for cooling an electrical component (12), the cooling system comprising:
a heat sink (16) configured to be positioned in thermal communication with the electrical component;
**characterized in that** the cooling system (10) further comprises:
a supply (14) of liquid natural gas (LNG); and
an LNG conduit (22) configured to be interconnected between the heat sink and the supply of LNG such that the LNG conduit is configured to carry LNG from the supply to the heat sink to absorb heat from the heat sink; and
a pump (20) configured to be operatively connected in fluid communication with the supply (14) of LNG, the pump being configured to move LNG within the LNG conduit (22) from the supply (14) to the heat sink (16).

2. The cooling system of claim 1, wherein the supply of LNG comprises a fuel tank (126) of an aircraft engine (124).

3. The cooling system (110) of either of claim 1 or 2, wherein the pump (128) comprises a fuel pump for an aircraft engine (124).

4. The cooling system (110) of any of the preceding claims, wherein the LNG is used as a fuel for an engine (124), the heat sink (216a,b) being configured to increase the temperature of the LNG toward a supply temperature at which the LNG is supplied to the engine in a gaseous state.

5. The cooling system of any of the preceding claims, wherein the heat sink (316) comprises a fluid block having at least one passageway (318) for receiving a flow of the LNG from the LNG conduit.

6. The cooling system of any of the preceding claims, wherein the LNG conduit comprises an insulated segment that extends a length from the supply of LNG to the heat sink (316), the insulated segment being thermally insulated along at least a portion of the length thereof, the LNG conduit comprising an uninsulated segment that extends from the insulated segment and is engaged with the heat sink (316).

7. The cooling system of any of the preceding claims, wherein the heat sink (416) comprises an exterior surface (422), the LNG conduit (22) being engaged with the exterior surface of the heat sink.

8. The cooling system of any of the preceding claims, wherein the heat sink (316) comprises an interior surface (322), the LNG conduit (22) being engaged with the interior surface of the heat sink.

9. The cooling system of any of the preceding claims, wherein the heat sink (16) is configured to be positioned in thermal communication with the electrical component (12) through at least one of:
engagement with the electrical component (12); or
engagement with a thermal interface material that is engaged with the electrical component (12).

10. The cooling system of any of the preceding claims, wherein the LNG conduit comprises an inner wall and an outer wall, the inner wall defining an inner passageway that is configured to carry the LNG, an outer passageway being defined between the inner wall and the outer wall, the outer passageway comprising a vacuum.

11. A method (300) for cooling an electrical component (12), the method comprising:
dissipating (304) heat from the electrical component by absorbing heat from a heat sink that is positioned in thermal communication with the electrical component;
**characterized in that** the method comprises;
supplying (302) a flow of liquid natural gas (LNG) from a supply of the LNG to the heat sink;
wherein the dissipating (304) heat from the electrical component by absorbing heat from the heat sink uses the LNG.

12. The method (300) of claim 11, wherein supplying the flow of LNG comprises supplying (302a) the flow of LNG from a fuel tank of an aircraft engine.

13. The method of either of claim 11 or 12, wherein dissipating heat from the electrical component by absorbing heat from the heat sink using the LNG comprises at least partially vaporizing (304a) the LNG.

14. The method of any of claims 11 to 13, wherein dissipating heat from the electrical component by absorbing heat from the heat sink using the LNG comprises increasing the temperature of the LNG toward a supply temperature at which the LNG is supplied to an engine in a gaseous state for use as by the engine as fuel.

15. An aircraft (100) comprising:
an airframe (114);
an electrical component (112) on-board the airframe; and
a cooling system (11) on-board the airframe, the cooling system being according to claim 1.

## Patentansprüche

1. Kühlsystem (10) zum Kühlen einer elektrischen Komponente (12), wobei das Kühlsystem Folgendes umfasst:
einen Kühlkörper (16), der dafür gestaltet ist, in thermischer Verbindung mit der elektrischen Komponente angeordnet zu sein,
**dadurch gekennzeichnet, dass** das Kühlsystem (10) ferner Folgendes umfasst:
eine Zufuhr (14) für flüssiges Erdgas (LNG - Liquid Natural Gas) und
eine LNG-Leitung (22), die so gestaltet ist, dass sie zwischen dem Kühlkörper und der LNG-Zufuhr eingebunden ist, wobei die LNG-Leitung dafür gestaltet ist, LNG von der Zufuhr zum Kühlkörper zu befördern, um Wärme vom Kühlkörper zu absorbieren, und
eine Pumpe (20), die dafür gestaltet ist, funktionsfähig in Fluidverbindung mit der LNG-Zufuhr (14) angeschlossen zu sein, wobei die Pumpe dafür gestaltet ist, LNG von der Zufuhr (14) zum Kühlkörper (16) in der LNG-Leitung (22) zu bewegen.

2. Kühlsystem nach Anspruch 1, wobei die LNG-Zufuhr einen Treibstofftank (126) eines Flugzeugmotors (124) umfasst.

3. Kühlsystem (110) nach Anspruch 1 oder 2, wobei die Pumpe (128) eine Treibstoffpumpe für einen Flugzeugmotor (124) umfasst.

4. Kühlsystem (110) nach einem der vorhergehenden Ansprüche, wobei das LNG als Treibstoff für einen Motor (124) verwendet wird und der Kühlkörper (216a, b) dafür gestaltet ist, die Temperatur des LNG in Richtung einer Zufuhrtemperatur zu erhöhen, bei der das LNG dem Motor in einem gasförmigen Zustand zugeführt wird.

5. Kühlsystem nach einem der vorhergehenden Ansprüche, wobei der Kühlkörper (316) einen Fluidblock umfasst, der mindestens einen Durchlassweg (318) zur Aufnahme eines LNG-Stromes von der LNG-Leitung aufweist.

6. Kühlsystem nach einem der vorhergehenden Ansprüche, wobei die LNG-Leitung ein isoliertes Segment umfasst, das sich über eine Länge von der LNG-Zufuhr zum Kühlkörper (316) erstreckt, wobei das isolierte Segment über mindestens einen Abschnitt seiner Länge thermisch isoliert ist, wobei die LNG-Leitung ein nicht isoliertes Segment umfasst, das sich vom isolierten Segment aus erstreckt und mit dem Kühlkörper (316) in Eingriff steht.

7. Kühlsystem nach einem der vorhergehenden Ansprüche, wobei der Kühlkörper (416) eine Außenfläche (422) umfasst, wobei die LNG-Leitung (22) mit der Außenfläche des Kühlkörpers in Eingriff steht.

8. Kühlsystem nach einem der vorhergehenden Ansprüche, wobei der Kühlkörper (316) eine Innenfläche (322) umfasst, wobei die LNG-Leitung (22) mit der Innenfläche des Kühlkörpers in Eingriff steht.

9. Kühlsystem nach einem der vorhergehenden Ansprüche, wobei der Kühlkörper (16) dafür gestaltet ist, durch mindestens eines der Folgenden in thermischer Verbindung mit der elektrischen Komponente (12) angeordnet zu sein:
Eingriff mit der elektrischen Komponente (12) oder
Eingriff mit einem thermischen Grenzflächenmaterial, das mit der elektrischen Komponente (12) in Eingriff steht.

10. Kühlsystem nach einem der vorhergehenden Ansprüche, wobei die LNG-Leitung eine Innenwand und eine Außenwand umfasst, wobei die Innenwand einen inneren Durchlassweg definiert, der dafür gestaltet ist, das LNG zu tragen, wobei zwischen der Innenwand und der Außenwand ein äußerer Durchlassweg definiert ist, wobei der äußere Durchlassweg ein Vakuum umfasst.

11. Verfahren (300) zum Kühlen einer elektrischen Komponente (12), wobei das Verfahren Folgendes umfasst:
Ableiten (304) von Wärme von der elektrischen Komponente durch Absorbieren von Wärme von einem Kühlkörper, der in thermischer Verbindung mit der elektrischen Komponente angeordnet ist,
**dadurch gekennzeichnet, dass** das Verfahren Folgendes umfasst:
Zuführen (302) eines Stromes flüssigen Erdgases (LNG) von einer LNG-Zufuhr zum Kühlkörper,
wobei das Ableiten (304) von Wärme von der elektrischen Komponente durch Absorbieren von Wärme vom Kühlkörper das LNG nutzt.

12. Verfahren (300) nach Anspruch 11, wobei das Zuführen des LNG-Stromes das Zuführen (302a) des LNG-Stromes von einem Treibstofftank eines Flugzeugmotors umfasst.

13. Verfahren nach Anspruch 11 oder 12, wobei das Ableiten von Wärme von der elektrischen Komponente durch Absorbieren von Wärme von dem Kühlkörper unter Nutzung des LNG das zumindest teilweise Verdampfen (304a) des LNG umfasst.

14. Verfahren nach einem der Ansprüche 11 bis 13, wobei das Ableiten von Wärme von der elektrischen Komponente durch Absorbieren von Wärme von dem Kühlkörper unter Nutzung des LNG das Erhöhen der Temperatur des LNG in Richtung einer Zufuhrtemperatur umfasst, bei der das LNG einem Motor in gasförmigem Zustand zugeführt wird, um von dem Motor als Treibstoff verwendet zu werden.

15. Flugzeug (100), Folgendes umfassend:
ein Flugwerk (114),
eine elektrische Komponente (112) an Bord des Flugwerks und
ein Kühlsystem (11) an Bord des Flugwerkes, wobei das Kühlsystem Anspruch 1 entspricht.

## Revendications

1. Système de refroidissement (10) pour refroidir un composant électrique (12), le système de refroidissement comprenant :
un puits de chaleur (16) configuré pour être positionné en communication thermique avec le composant électrique ;
**caractérisé en ce que** le système de refroidissement (10) comprend en outre :
une source d'alimentation de gaz naturel liquéfié (GNL) (14) ; et
une conduite de GNL (22) configurée pour être interconnectée entre le puits de chaleur et la source d'alimentation de GNL de telle sorte que la conduite de GNL soit configurée pour transporter du GNL de la source d'alimentation au puits de chaleur afin d'absorber de la chaleur du puits de chaleur ; et
une pompe (20) configurée pour être raccordée en service en communication fluidique avec la source d'alimentation de GNL (14), la pompe étant configurée pour transporter du GNL dans la conduite de GNL (22) de la source d'alimentation (14) au puits de chaleur (16).

2. Système de refroidissement selon la revendication 1, dans lequel la source d'alimentation de GNL comprend un réservoir de carburant (126) d'un moteur d'aéronef (124).

3. Système de refroidissement (110) selon la revendication 1 ou la revendication 2, dans lequel la pompe (128) comprend une pompe à carburant pour un moteur d'aéronef (124).

4. Système de refroidissement (110) selon l'une quelconque des revendications précédentes, dans lequel le GNL est utilisé comme carburant pour un moteur (124), le puits de chaleur (216a, b) étant configuré pour augmenter la température du GNL vers une température d'alimentation à laquelle le GNL est fourni au moteur à l'état gazeux.

5. Système de refroidissement selon l'une quelconque des revendications précédentes, dans lequel le puits de chaleur (316) comprend un bloc de fluide ayant au moins un passage (318) pour recevoir un flux de GNL depuis la conduite de GNL.

6. Système de refroidissement selon l'une quelconque des revendications précédentes, dans lequel la conduite de GNL comprend un segment isolé qui s'étend sur une certaine longueur depuis la source d'alimentation de GNL jusqu'au puits de chaleur (316), le segment isolé étant thermiquement isolé le long d'au moins une portion de sa longueur, la conduite de GNL comprenant un segment non isolé qui s'étend depuis le segment isolé et vient en contact avec le puits de chaleur (316).

7. Système de refroidissement selon l'une quelconque des revendications précédentes, dans lequel le puits de chaleur (416) comprend une surface externe (422), la conduite de GNL (22) venant en contact avec la surface externe du puits de chaleur.

8. Système de refroidissement selon l'une quelconque des revendications précédentes, dans lequel le puits de chaleur (316) comprend une surface interne (322), la conduite de GNL (22) venant en contact avec la surface interne du puits de chaleur.

9. Système de refroidissement selon l'une quelconque des revendications précédentes, dans lequel le puits de chaleur (16) est configuré pour être disposé en communication thermique avec le composant électrique (12) via au moins un des contacts suivants :
un contact avec le composant électrique (12) ; ou
un contact avec un matériau d'interface thermique qui vient en contact avec le composant électrique (12).

10. Système de refroidissement selon l'une quelconque des revendications précédentes, dans lequel la conduite de GNL comprend une paroi interne et une paroi externe, la paroi interne définissant un passage interne qui est configuré pour acheminer le GNL, un passage externe étant défini entre la paroi interne et la paroi externe, le passage externe comprenant un vide.

11. Procédé (300) pour refroidir un composant électrique (12), le procédé comprenant les étapes consistant à :
dissiper (304) la chaleur venant du composant électrique en absorbant la chaleur d'un puits de chaleur qui est positionné en communication thermique avec le composant électrique ;
**caractérisé en ce que** le procédé comprend les étapes consistant à :
acheminer (302) un flux de gaz naturel liquéfié (GNL) d'une source d'alimentation de GNL au puits de chaleur ;
dans lequel la dissipation (304) de la chaleur du composant électrique par absorption de chaleur du puits de chaleur utilise le GNL.

12. Procédé (300) selon la revendication 11, dans lequel l'alimentation d'un flux de GNL comprend l'alimentation (302a) du flux de GNL d'un réservoir de carburant d'un moteur d'aéronef.

13. Procédé selon l'une quelconque des revendications 11 ou 12, dans lequel la dissipation de chaleur du composant électrique par absorption de chaleur du puits de chaleur en utilisant le GNL comprend une vaporisation au moins partielle (304a) du GNL.

14. Procédé selon l'une quelconque des revendications 11 à 13, dans lequel la dissipation de chaleur du composant électrique par absorption de la chaleur du puits de chaleur en utilisant le GNL comprend l'augmentation de la température du GNL vers une température d'alimentation à laquelle le GNL est fourni à un moteur à l'état gazeux pour une utilisation comme carburant par le moteur.

15. Aéronef (100) comprenant :
une cellule d'aéronef (114) ;
un composant électrique (112) à bord de la cellule d'aéronef ; et
un système de refroidissement (11) à bord de la cellule d'aéronef, le système de refroidissement étant conforme à la revendication 1.
